# EUROPÄISCHE PATENTSCHRIFT

(11) **EP 0 536 152 B1**
(45) Veröffentlichungstag und Bekanntmachung des Hinweises auf die Patenterteilung: **01.02.1995**
(21) Anmeldenummer: 91909456.5
(22) Anmeldetag: 27.05.1991
(51) Int. Cl.: H01L 29/06

(54) **MONOLITHISCH INTEGRIERTE HALBLEITERANORDNUNG MIT EINER DECKELEKTRODE**
MONOLITHICALLY INTEGRATED SEMICONDUCTOR ARRANGEMENT WITH A COVER ELECTRODE
DISPOSITIF SEMI-CONDUCTEUR MONOLITHIQUE INTEGRE AVEC UNE ELECTRODE DE COUVERTURE

(30) Priorität: 28.06.1990 DE 4020519
(43) Veröffentlichungstag der Anmeldung: 14.04.1993
(73) Patentinhaber: ROBERT BOSCH GMBH, 70442 Stuttgart (DE)
(72) Erfinder: FLOHRS, Peter, D-7410 Reutlingen 11 (DE); PLUNTKE, Christian, D-7410 Reutlingen (DE)
(86) Internationale Anmeldenummer: DE9100445
(87) Internationale Veröffentlichungsnummer: WO9200606

(56) Entgegenhaltungen:
- WO-A-83/01709
- WO-A-83/02528
- US-A- 4 074 293
- INTERNATIONAL ELECTRON DEVICES MEETING, December 5-7, 1983, Washington DC, IEEE, USA, pp. 412-415 ; Y. Sugawara et al. : "Practical Size Limits of High Voltage IC's".

## Beschreibung

### Stand der Technik

Die Erfindung betrifft eine monolithisch integrierte Halbleiteranordnung nach dem Oberbegriff des Anspruchs 1.

Bei einer bekannten, monolithisch integrierten, Halbleiteranordnung (DE-OS 32 27 536) weist ein Substrat unter einer ersten Hauptoberfläche eine schwache Dotierung (Substratbereich n⁻) und unter einer zweiten Hauptoberfläche, mindestens bei der fertigen Anordnung, eine hohe Dotierung des gleichen Leitfähigkeitstyps (Substratbereich n⁺) auf. Von der ersten Hauptoberfläche sind eine erste Zone (p), die mit dem Substrat einen pn-Übergang bildet, und eine zweite Zone (n⁺) vom gleichen Leitfähigkeitstyp wie das Substrat, die aber die erste Zone (p) nicht berührt, eindiffundiert.

Die erste Hauptoberfläche des Substrats wird mit Ausnahme von Kontaktfenstern von einer isolierenden Passivierungsschicht bedeckt. Über dieser Schicht liegt eine metallische Deckelektrode, die an die erste Hauptoberfläche grenzende Substratgebiete (Substratbereich n⁻), die Randgebiete der ersten Zone (p) und die Randgebiete der zweiten Zone (n⁺) überdeckt.

Durch die über dem Raumladungsgebiet liegende, metallische Deckelektrode wird hier ein Schutz einer planaren Transistoranordnung gegen Umgebungseinflüsse, gegebenenfalls verbunden mit einer Beeinflussung der Durchbruchspannung erreicht. Die Deckelektrode liegt dazu auf einem durch einen Spannungsteiler bestimmten Potential zwischen Basis und Kollektor. Die Durchbruchspannung wird im wesentlichen durch dieses Potential und die Dicke des Oxids unter der Deckelektrode bestimmt.

Die Verwendung eines Spannungsteilers ist eine relativ aufwendige Maßnahme, wobei dessen Integration in die Halbleiteranordnung Siliziumfläche beansprucht. Zudem ist es wünschenswert, bei gleicher Oxiddicke eine höhere Durchbruchspannung zu erreichen. Das wird erfindungsgemäß durch eine Ausbildung der Halbleiteranordnung nach dem kennzeichnenden Teil des Anspruchs 1 erreicht.

### Vorteile der Erfindung

Durch Eindiffusion von einer der zweiten Zone (n⁺) zugeordneten, die erste Zone (p) nicht berühenden zusätzlichen Zone (π) die vom gleichen Leitfähigkeitstyp, jedoch mit geringerer Dotierung wie die zweite Zone (n⁺) ist, kann bei gleicher Oxiddicke eine gegenüber der bekannten Halbleiteranordnung höhere Durchbruchspannung erreicht werden. Damit wird es in bestimmten Fällen möglich, auf einen Spannungsteiler zum Anschluß der Deckelektrode zu verzichten und die gewünschte Sperrfähigkeit curch eine Verbindung der Deckelektrode mit der Basis/Anode bzw. Kollektor/Kathode zu erreichen.

### Zeichnung

Die Erfindung wird anhand der Zeichnung näher erläutert.

Es zeigen:
- Fig. 1: eine monolithisch integrierte Halbleiteranordnung mit einem Spannungsteiler nach dem Stand der Technik,
- Fig. 2: eine erfindungsgemäße monolithisch integrierte Halbleiteranordnung mit einer zusätzlichen Zone (Zone ν), die einer n⁺-Zone zugeordnet ist,
- Fig. 3: eine monolithisch integrierte Halbleiteranordnung mit einer zusätzlichen Zone (Zone π), die einer p-Zone zugeordnet ist,
- Fig. 4: eine erfindungsgemäße Halbleiteranordnung, die beide zusätzlichen Zonen (Zone ν und Zone π) aus den Fig. 2 und 3 enthält,
- Fig. 5: eine beschaltete Halbleiteranordnung nach Fig. 2,
- Fig. 6: eine beschaltete Halbleiteranordnung nach Fig. 3,
- Fig. 7: ein Diagramm, das im Vergleich mit dem Stand der Technik den Anstieg der Durchbruchspannung bei Verwendung der zusätzlichen Zone nach Fig. 2 (Zone ν) zeigt und
- Fig. 8: ein Diagramm, das im Vergleich mit dem Stand der Technik den Anstieg der Durchbruchspannung bei Verwendung der zusätzlichen Zone nach Fig. 3 (Zone π) darstellt.

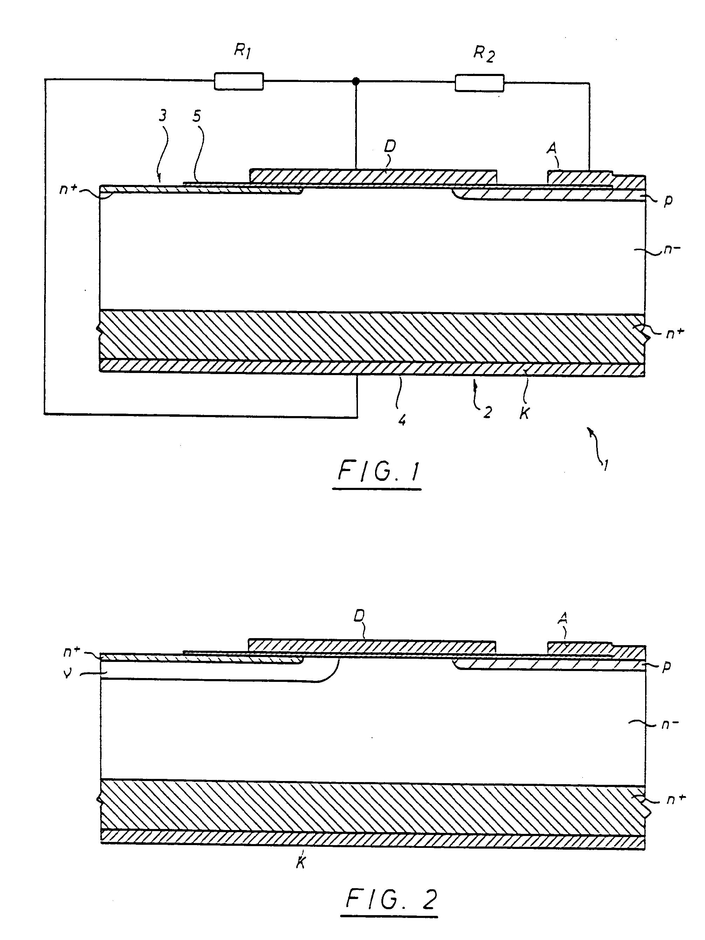

Allgemein ist festzustellen, daß die Erfindung bei Transistoren in Planartechnik angewendet werden soll. Da der Emitter dabei keine Rolle spielt, sind die Fig. 1 bis 6 auf die Darstellung der Basis-Kollektor-Diode eines npn-Transistors beschränkt. Die Basis ist dabei mit A (Anode) und der Kollektor mit K (Kathode) bezeichnet.

Sinngemäß ist die Erfindung auch für pnp-Transistoren geeignet, wobei jeweils p- und n-Dotierung zu vertauschen sind.

In Fig. 1 ist eine monolithisch integrierte Halbleiteranordnung 1 dargestellt, deren Ausgangsmaterial für die Herstellung ein Silizium-Substrat 2 ist, das auf der Vorderseite (erste Hauptoberfläche 3) schwach (Substratbereich n⁻) und auf der Rückseite (zweite Hauptoberfläche 4) hoch dotiert (Substratbereich n⁺) ist.

Auf der Vorderseite 3 sind in bekannter Weise mittels Fototechnik, Dotierung und Diffusion eine erste Zone (p), die mit dem Substrat 2 einen pn-Übergang bildet und eine zweite Zone (n⁺) vom gleichen Leitfähigkeitstyp wie das Substrat hergestellt. Die erste Zone (p) und die zweite Zone (n⁺) berühren sich nicht. Die zweite Zone (n⁺) kann gleichzeitig mit dem Emitter eindiffundiert werden.

Die Vorderseite 3 ist mit Ausnahme von Kontaktfenstern mit einer isolierenden Passivierungsschicht 5 bedeckt, über der eine metallische Deckelektrode D angeordnet ist. Die Deckelektrode D überdeckt das an die Vorderseite 3 grenzende Substratgebiet (Substratbereich n⁻), die Randgebiete der ersten Zone (p) und die Randgebiete der zweiten Zone (n⁺).

An der Vorderseite 3 und mit der ersten Zone (p) verbunden liegt der Anschluß für die Anode A. Auf der Rückseite 4 mit dem Substratbereich (n⁺) verbunden liegt der Anschluß für die Kathode K (Kollektor). Die zweite Zone (n⁺) begrenzt die Raumladung auf Gebiete unter der Deckelektrode, wenn zwischen der Anode A und der Kathode K Sperrspannung angelegt wird.

Nach dem Stand der Technik gemäß Fig. 1 kann die Deckelektrode D an einen durch Widerstände R₁ und R₂ gebildeten Spannungsteiler zwischen der Anode A und der Kathode K angeschlossen werden. Die im Falle von R₁ bzw. R₂ = 0 zwischen der Anode A und der Kathode K erreichbaren Durchbruchspannungen sind U₁ bzw. U₂. Dabei ist U₁ die Anreicherungsdurchbruchspannung und U₂ die Verarmungsdurchbruchspannung der durch die Deckelektrode D, das darunterliegende Oxid 5 und das Silizium 2 gebildeten MOS-Struktur. Die maximal erreichbare Durchbruchspannung ist U₁ + U₂, wenn R₁ : R₂ = U₂ : U₁. Aus dem Stand der Technik ist es auch bekannt, wie der Spannungsteiler R₁/R₂ monolithisch integriert werden kann, in der Weise, daß der Widerstand R₁ anstelle mit der Kathode K mit der praktisch auf gleichem Potential liegenden zweiten Zone (n⁺) auf der Vorderseite 3 verbunden wird. Weiter ist es bekannt, wie die Sperrspannung zwischen der Anode A und K abgleichbar gemacht werden kann, beispielsweise durch Zener-Dioden in Reihe zu den Widerständen, die bei Bedarf kurzgeschlossen werden.

In der erfindungsgemäßen Halbleiteranordnung nach Fig. 2 überdeckt die Deckelektrode D zusätzlich eine an die zweite Zone (n+) grenzende, zusätzliche Zone (Zone ν), deren Oberflächenkonzentration geringer ist als die der zweiten Zone (n⁺).

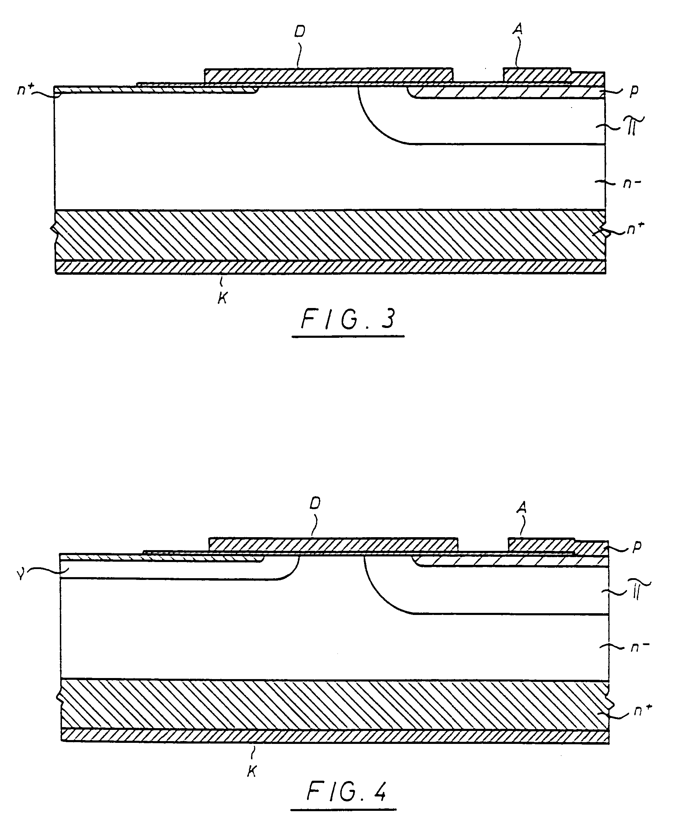

In der Halbleiteranordnung nach Fig. 3 überdeckt die Deckelektrode D zusätzlich eine an die erste Zone (p) grenzende, zusätzliche Zone (Zone π), deren Oberflächenkonzentration geringer ist als die der ersten Zone (p). Aus US-A-4 074 293 ist bekannt, daß eine derartige Ausführung eines pn-Übergangs zu einer wesentlich höheren Durchbruchspannung führen kann.

In der erfindungsgemäßen Halbleiteranordnung nach Fig. 4 sind beide zusätzlichen Zonen (Zone ν und Zone π) vorhanden.

Beide zusätzlichen Zonen ν und π werden in bekannter Weise mittels Fototechnik, Dotierung und Diffusion hergestellt.

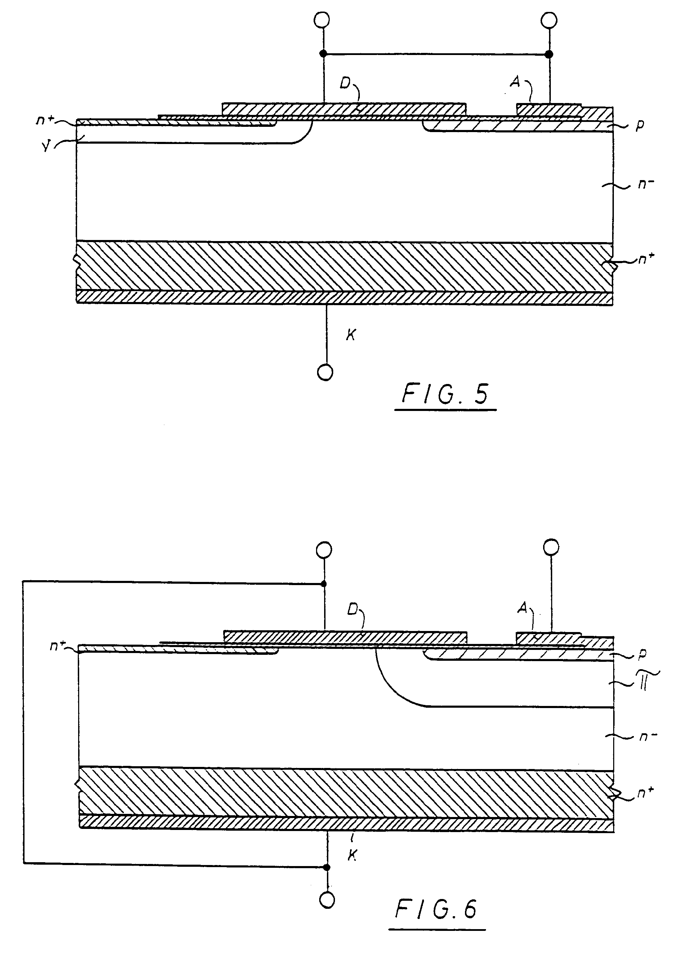

In Fig. 5 ist eine Anordnung entsprechend der Fig. 2 mit einer zusätzlichen Zone ν dargestellt, bei der die Deckelektrode D und die Anode A verbunden sind bzw. die Deckelektrode D auf das gleiche Potential wie die erste Zone (p) gelegt ist.

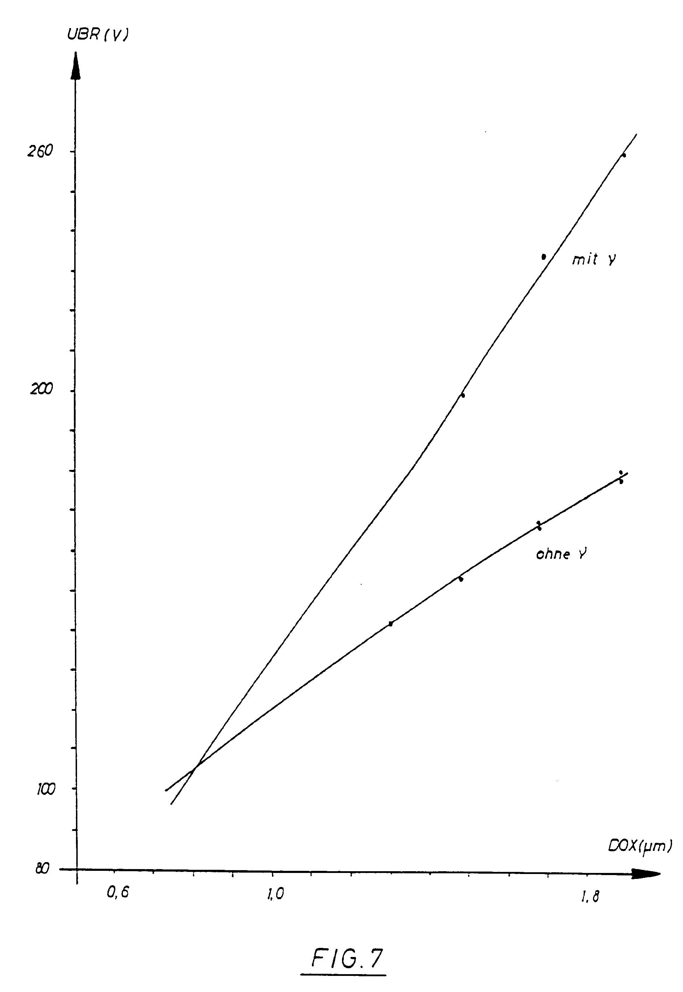

Aus dem Diagramm nach Fig. 7 ist der Nutzen der zusätzlichen Zone ν zu entnehmen. Dabei ist die Verarmungsdurchbruchspannung zwischen der Anode A und der Kathode K eingezeichnet, für den Fall ohne der zusätzlichen Zone ν (unterer Kurvenast) und mit der zusätzlichen Zone ν (oberer Kurvenast). Nach oben ist die Durchbruchspannung aufgetragen und nach rechts die Dicke der Oxidschicht unter der Deckelektrode D. Es ist zu entnehmen, daß je nach der Dicke der Oxidschicht zum Teil deutlich höhere Werte für die Durchbruchspannung erreicht werden, wenn eine zusätzliche Zone ν verwendet wird.

In Fig. 6 ist eine Halbleiteranordnung entsprechend Fig. 3 mit einer zusätzlichen Zone π dargestellt, wobei die Deckelektrode D mit der Kathode K verbunden ist bzw. die Deckelektrode D und die Kathode K auf das gleiche Potential gelegt werden, wobei auch eine Verbindung mit der zweiten Zone (n⁺) möglich ist.

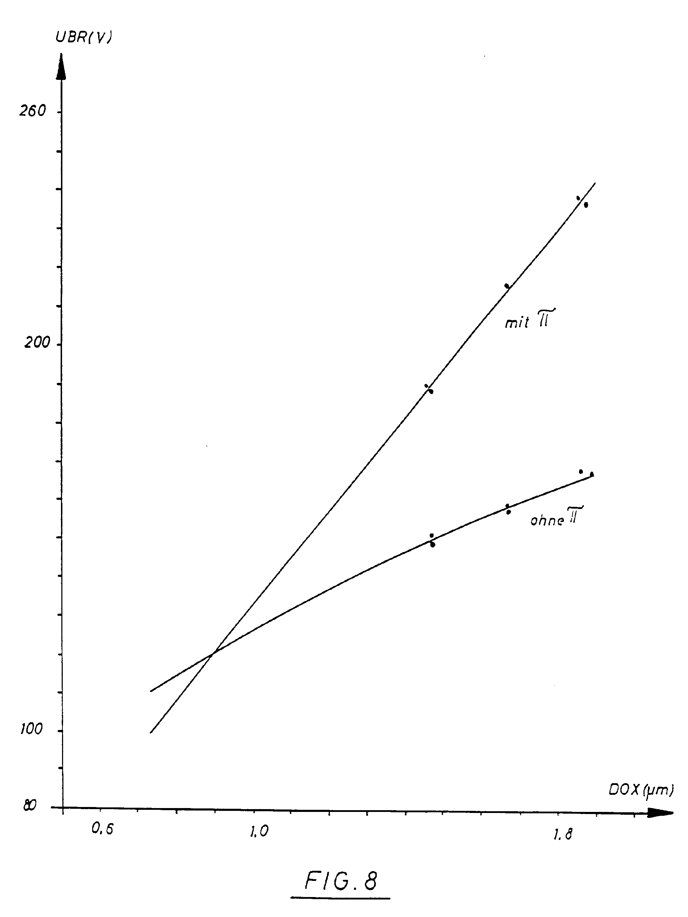

In Fig. 8 ist dabei ähnlich wie in Fig. 7 die Anreicherungsdurchbruchspannung mit und ohne der zusätzlichen Zone π eingezeichnet. Auch hieraus ist zu entnehmen, daß je nach Dicke der Oxidschicht unter der Deckelektrode D deutlich höhere Werte für die Durchbruchspannung erreicht werden, wenn eine zusätzliche Zone π eingebracht wird.

Anordnungen entsprechend den Fig. 5 und 6 machen es daher in bestimmten Fällen möglich, eine gewünschte Sperrfähigkeit zwischen der Anorde und Kathode auch ohne die Siliziumfläche beanspruchende Integration eines Spannungsteilers zu erreichen.

Eine Anordnung entsprechend der Fig. 4 ist dann nützlich, wenn in Verbindung mit einem Spannungsteiler R₁/R₂ eine höhere Sperrfähigkeit gewünscht wird.

## Patentansprüche

1. Monolithisch integrierte Halbleiteranordnung, bei der in ein Substrat (2), das unter einer ersten Hauptoberfläche (3) eine schwache Dotierung (n⁻) und unter einer zweiten Hauptoberfläche (4) eine hohe Dotierung des gleichen Leitfähigkeitstyps (n⁺) aufweist, von der ersten Hauptoberfläche (3) eine erste Zone (p), die mit dem Substrat (2) einen pn-Übergang bildet, und eine zweite Zone (n⁺) von gleichem Leitfähigkeitstyp wie das Substrat (2), die die erste Zone (p) nicht berührt, eindiffundiert sind und bei der eine die erste Hauptoberfläche (3) des Substrats (2) mit Ausnahme von Kontaktfenstern bedeckende isolierende Passivierungsschicht (5) und eine über dieser Schicht (5) liegende metallische Deckelektrode (D), die an die erste Hauptoberfläche (3) grenzende Substratgebiete (n⁻), Randgebiete der ersten Zone (p) und Randgebiete der zweiten Zone (n⁺) überdeckt, vorgesehen sind, **dadurch gekennzeichnet**, daß von der ersten Hauptoberfläche (3) eine der zweiten Zone (n⁺) zugeordnete, die erste Zone (p) nicht berührende zusätzliche Zone (ν) eindiffundiert ist, die vom gleichen Leitfähigkeitstyp, jedoch mit geringerer Dotierung wie die zweite Zone (n⁺) ist, die unterhalb der zweiten Zone (n⁺) liegt und deren Randgebiet im Bereich der Deckelektrode (D) umfassen und somit verhindern, daß unterhalb der Deckelektrode (D) die zweite Zone (n⁺) direkt an das Substrat (2) (n⁻) angrenzt.

2. Monolithisch integrierte Halbleiteranordnung nach Anspruch 1, dadurch gekennzeichnet, daß von der ersten Hauptoberfläche (3) eine der ersten Zone (p) zugeordnete zusätzliche Zone (π) eindiffundiert ist, die die der zweiten Zone (n⁺) zugeordnete zusätzliche Zone (ν) nicht berührt, die vom gleichen Leitfähigkeitstyp, jedoch von geringerer Dotierung wie die erste Zone (p) ist, die unterhalb der ersten Zone (p) liegt und deren Randgebiet im Bereich der Deckelektrode (D) umfassen und somit verhindern, daß unterhalb der Deckelektrode (D) die erste Zone (p) direkt an das Substrat (2) (n⁻) angrenzt.

3. Monolithisch integrierte Halbleiteranordnung nach Anspruch 1 oder 2, dadurch gekennzeichnet, daß die Deckelektrode (D) auf das Potential der zweiten Zone (n⁺) oder der zweiten Hauptoberfläche (4) des Substrats (2) gelegt ist.

4. Monolithisch integrierte Halbleiteranordnung nach Anspruch 1 oder 2, dadurch gekennzeichnet, daß die Deckelektrode (D) auf das gleiche Potential gelegt ist wie die erste Zone (p) oder höchstens eine oder mehrere Diodenflußspannungen davon verschieden.

5. Anordnung nach Anspruch 1 oder 2, dadurch gekennzeichnet, daß die Deckelektrode (D) durch einen Spannungsteiler (R₁/R₂) auf ein Potential zwischen dem der ersten Zone (p) und der zweiten Zone (n⁺) oder der zweiten Hauptoberfläche (4) des Substrats (2) gelegt ist.

6. Anordnung nach Anspruch 5, dadurch gekennzeichnet, daß der Spannungsteiler (R₁/R₂) ohmsch ist und monolithisch integriert ist.

7. Anordnung nach Anspruch 6, dadurch gekennzeichnet, daß der Spannungsteiler (R₁/R₂) abgleichbar ist, insbesondere durch kurzzuschließende Zener-Dioden in Reihe zu mindestens einem der Teilwiderstände oder parallel zu Teilwiderständen des Spannungsteilers (R₁/R₂).

## Claims

1. Monolithically integrated semiconductor arrangement, in the case of which a first zone (p), which forms a pn-junction with a substrate (2), and a second zone (n⁺), which is of the same conductance type as the substrate (2) and does not touch the first zone (p), are diffused into the substrate (2) which has weak doping (n⁻) under a first main surface (3) and strong doping of the same conductance type (n⁺) under a second main surface (4), and in the case of which an insulating passivation layer (5), which covers the first main surface (3) of the substrate (2) with the exception of contact windows, and a metallic covering electrode (D), which is located above this layer (5) and covers substrate regions (n⁻) bounding the first main surface (3), edge regions of the first zone (p) and edge regions of the second zone (n⁺) are provided, characterized in that an additional zone (ν) which is assigned to the second zone (n⁺) but does not touch the first zone (p) is diffused in from the first main surface (3), which additional zone (ν) is of the same conductance type as, but has weaker doping than, the second zone (n⁺), is located underneath the second zone (n⁺) and surrounds its edge region in the area of the covering electrode (D) and thus prevents the second zone (n⁺) being directly adjacent to the substrate (2) (n⁻) underneath the covering electrode (D).

2. Monolithically integrated semiconductor arrangement according to Claim 1, characterized in that an additional zone (π), which is assigned to the first zone (p), is diffused in from the first main surface (3), which additional zone (π) does not touch the additional zone (ν) which is assigned to the second zone (n⁺) and is of the same conductance type as, but with weaker doping than, the first zone (p), is located underneath the first zone (p) and surrounds its edge region in the area of the covering electrode (D) and thus prevents the first zone (p) being directly adjacent to the substrate (2) (n⁻) underneath the covering electrode (D).

3. Monolithically integrated semiconductor arrangement according to Claim 1 or 2, characterized in that the covering electrode (D) is connected to the potential of the second zone (n⁺) or of the second main surface (4) of the substrate (2).

4. Monolithically integrated semiconductor arrangement according to Claim 1 or 2, characterized in that the covering electrode (D) is connected to the same potential as the first zone (p) or is at most one or more diode forward voltages different therefrom.

5. Arrangement according to Claim 1 or 2, characterized in that the covering electrode (D) is connected through a voltage divider (R₁/R₂) to a potential between that of the first zone (p) and of the second zone (n⁺) or of the second main surface (4) of the substrate (2).

6. Arrangement according to Claim 5, characterized in that the voltage divider (R₁/R₂) is resistive and is monolithically integrated.

7. Arrangement according to Claim 6, characterized in that the voltage divider (R₁/R₂) is tunable, especially by means of zener diodes, which can be short-circuited, in series with at least one of the resistance elements or in parallel with the resistance elements of the voltage divider (R₁/R₂).

## Revendications

1. Dispositif semi-conducteur monolithique intégré, dans lequel sur un substrat (2), qui sous une première surface principale (3) comporte un dopage faible (n⁻) et dessous une deuxième surface principale (4) comporte un dopage élevé du même type de conductibilité (n⁺), sont diffusées à partir de la première surface principale (3) une première zone (p), qui forme avec le substrat (2) une jonction pn, et une deuxième zone (n⁺) de même type de conductibilité que le substrat (2), qui ne touche pas la première zone (p), et dans lequel il est prévu une couche isolante de passivation (5) recouvrant la première surface principale (3) du substrat (2) à l'exception de fenêtres de contact et, placée sur cette couche (5), une électrode métallique de couverture (D), qui recouvre les régions du substrat (n⁻) limitrophes de la première surface principale (3), les régions de bordure de la première zone (p) et les régions de bordure de la deuxième zone (n⁺), dispositif semi-conducteur monolithique intégré caractérisé en ce que à partir de la première surface principale (3) est diffusée une zone supplémentaire (ν) associée à la seconde zone (n⁺) et ne touchant pas la première zone (p), cette zone (ν) étant du même type de conductibilité, mais avec un dopage moindre, que la deuxième zone (n⁺), et se situant au-dessous de cette deuxième zone (n⁺) et entourant la région de bordure de celle-ci dans la zone de l'électrode de couverture (D) et empêchant ainsi, qu'au-dessous de l'électrode de couverture (D), la deuxième zone (n⁺) soit directement limitrophe du substrat (2) (n⁻).

2. Dispositif semi-conducteur monolithique intégré selon la revendication 1, caractérisé en ce que à partir de la première surface principale (3) est diffusée une zone supplémentaire (π) associée à la première zone (p) et qui ne touche pas la zone supplémentaire (ν) associée à la seconde zone (n⁺), cette zone supplémentaire (π) étant du même type de conductibilité mais avec un dopage moindre que la première zone (p), et se situant au-dessous de cette première zone (p), dont elle entoure la région de bordure dans la zone de l'électrode de couverture (D) et empêche ainsi qu'au-dessous de l'électrode de couverture (D) la première zone (p) soit directement limitrophe du substrat (2) (n⁻).

3. Dispositif semi-conducteur monolithique intégré selon la revendication 1 ou la revendication 2 caractérisé en ce que l'électrode de couverture (D) est mise au potentiel de la deuxième zone (n⁺) ou bien de la deuxième surface principale (4) du substrat (2).

4. Dispositif semi-conducteur monolithique intégré selon la revendication 1 ou la revendication 2 caractérisé en ce que l'électrode de couverture (D) est mise au même potentiel que la première zone (p) ou bien en en différant au plus d'une ou plusieurs tensions de flux de diodes.

5. Dispositif selon la revendication 1 ou la revendication 2 caractérisé en ce que l'électrode de couverture (D) est mise par un diviseur de tension (R₁/R₂) à un potentiel entre celui de la première zone (p) et de la deuxième zone (n⁺) ou bien de la deuxième surface principale (4) du substrat (2).

6. Dispositif selon la revendication 5 caractérisé en ce que le diviseur de tension (R₁/R₂) est ohmique et monolithique intégré.

7. Dispositif selon la revendication 6 caractérisé en ce que le diviseur de tension (R₁/R₂) est susceptible d'être réglé, notamment par des diodes de Zener court-circuitantes, en série par rapport à au moins une des résistances partielles du diviseur de tension (R₁/R₂) ou bien en parallèle par rapport à ces résistances partielles.
